(19) Europäisches Patentamt / European Patent Office / Office européen des brevets

(11) **EP 4 045 878 B1**

(12) **FASCICULE DE BREVET EUROPEEN**

(45) Date de publication et mention de la délivrance du brevet:
**06.11.2024 Bulletin 2024/45**

(21) Numéro de dépôt: **20789615.0**

(22) Date de dépôt: **14.10.2020**

(51) Classification Internationale des Brevets (IPC):
*G01D 21/00* (2006.01)  *G01J 5/20* (2006.01)
*G01J 5/34* (2022.01)  *G01K 7/16* (2006.01)
*G01L 1/14* (2006.01)  *G01K 7/36* (2006.01)
*G01L 9/00* (2006.01)  *G01D 5/12* (2006.01)
*G01N 27/22* (2006.01)

(52) Classification Coopérative des Brevets (CPC):
**G01D 21/00; G01J 5/20; G01J 5/34; G01K 7/16;**
**G01K 7/36; G01L 1/14; G01L 9/0004; G01L 9/007;**
G01D 5/12; G01N 2027/222

(86) Numéro de dépôt international:
**PCT/EP2020/078850**

(87) Numéro de publication internationale:
**WO 2021/074193 (22.04.2021 Gazette 2021/16)**

(54) **CAPTEUR A VARIATION D'INDUCTANCE CONSECUTIVE A UNE VARIATION D'UN MESURANDE**

SENSOR MIT INDUKTIVITÄTSÄNDERUNG INFOLGE EINER ÄNDERUNG EINER MESSGRÖSSE

SENSOR WITH INDUCTANCE CHANGE DUE TO A CHANGE IN A MEASURED VARIABLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.10.2019 FR 1911713**

(43) Date de publication de la demande:
**24.08.2022 Bulletin 2022/34**

(73) Titulaires:
• **Université d'Aix-Marseille**
  **13007 Marseille (FR)**
• **Centre national de la recherche scientifique**
  **75016 Paris (FR)**
• **Université de Toulon**
  **83130 La Garde (FR)**

(72) Inventeur: **BENEVENT, Evangéline**
**13004 Marseille (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
EP-A2- 2 084 521    EP-A2- 2 084 521
WO-A1-2019/119981    WO-A1-2019/119981
DE-A1- 3 638 286    DE-A1- 3 638 286
US-A1- 2005 284 231    US-A1- 2005 284 231
US-A1- 2014 019 067    US-A1- 2014 019 067
US-A1- 2014 028 327    US-A1- 2014 028 327

**Description**

DOMAINE TECHNIQUE DE L'INVENTION

L'invention se situe dans le domaine des dispositifs pour déterminer un mesurande et concerne notamment un capteur à variation d'impédance. L'invention vise en particulier un dispositif pour déterminer un mesurande comprenant un premier motif en une première matière conductrice, un second motif en une seconde matière et un moyen de détermination de l'impédance entre les extrémités du premier motif. L'invention concerne plus précisément un dispositif de mesure de l'inductance qui est dépendante du mesurande.

ETAT DE LA TECHNIQUE

Dans de nombreux domaines d'application et en particulier dans le domaine des capteurs, une détection sensible et/ou une mesure précise d'un mesurande est continuellement recherchée. Certains capteurs sont des dispositifs sensibles à un mesurande, une grandeur physique ou chimique d'intérêt, et transforment cette grandeur physique ou chimique d'intérêt en une grandeur électrique. Le mesurande peut par exemple être la température, la pression ou bien un gaz.

Certains capteurs comprenant une bande conductrice, c'est-à-dire capable de conduire l'électricité, sont configurés pour répondre à la variation discrète ou continue d'un mesurande par une modification dimensionnelle, c'est-à-dire une modification de la forme du capteur. Par exemple, une modification dimensionnelle du capteur peut se présenter par le déplacement d'un élément conducteur du capteur par rapport un autre élément conducteur du capteur, les éléments du capteur étant mobiles entre eux.

Ces capteurs sont par exemple configurés de telle manière que la modification dimensionnelle du capteur ait pour conséquence une variation de l'impédance de la bande conductrice du circuit. L'impédance est la caractéristique électrique d'un circuit qui définit l'opposition que rencontre un courant pour circuler dans un circuit. Dans de tels capteurs, une mesure de l'impédance entre chaque extrémité de la bande conductrice avant, pendant et après la variation du mesurande permet de détecter ou de mesurer une variation discrète ou continue de l'impédance. Cette variation d'impédance est relative à la variation du mesurande et un étalonnage de cette variation d'impédance permet ainsi d'obtenir un capteur de variation d'un mesurande.

La demande de brevet US20080007384 divulgue une inductance variable pour circuits à haute fréquence comprenant un premier substrat fixe avec une bande métallique conductrice fixe et une feuille conductrice disposée sur un second substrat mobile. Le second substrat est configuré de telle manière qu'il se déplace par rapport au premier substrat et permet d'effectuer une modification dimensionnelle du capteur. Le déplacement du second substrat déplace également la feuille conductrice de manière à modifier la géométrie de la bande métallique conductrice fixe, ce qui a pour conséquence de modifier la valeur de l'inductance donc la valeur de l'impédance générée aux bornes de l'inductance. Le second substrat mobile permet ainsi de modifier l'inductance générée par une modification du positionnement relatif dans l'espace du second substrat par rapport à la bande métallique conductrice fixe disposée sur le premier substrat.

La demande de brevet WO2008011260 divulgue un capteur inductif répondant à un paramètre d'intérêt et comprenant des boucles conductrices raccordées mécaniquement par au moins une charnière. Le capteur inductif est configuré pour répondre à un paramètre d'intérêt par une modification dimensionnelle de la forme du capteur, les boucles conductrices tournant autour des charnières lorsque le paramètre d'intérêt varie. Plus précisément, lorsque le paramètre d'intérêt varie, les positions relatives des boucles conductrices vont être modifiées par la rotation des boucles conductrices autour des charnières, entrainant une modification de l'inductance du capteur. Par exemple, le capteur selon la demande de brevet WO200811260 comprend des boucles conductrices disposées sur un substrat flexible dont les charnières sont formées par des pliures du substrat flexible. Lorsque le paramètre d'intérêt varie, les positions relatives des boucles conductrices vont être modifiées par la rotation des boucles conductrices autour des charnières par exemple en se rapprochant, impliquant un changement d'angle entre les boucles et donc une modification de l'inductance.

La demande de brevet US 2005/284231 A1 décrit un dispositif inductif de détection d'une contrainte comprenant deux motifs de matériaux différents.

Les dispositifs de l'état de l'art présentent une variation d'un paramètre du circuit, tel que l'impédance ou l'inductance, dépendant d'une modification dimensionnelle du dispositif ou bien dépendant d'une modification du positionnement relatif des différents éléments du dispositif. De tels dispositifs sont sensibles à des contraintes mécaniques qui pourraient déplacer ou déformer les éléments du dispositif et auraient pour conséquence de faire varier un paramètre du circuit tel que l'impédance ou l'inductance sans que le mesurande n'ait varié. De plus, de tels dispositifs nécessitent des conditionnements mécaniques qui assurent un environnement et un espace suffisant à la mise en oeuvre du dispositif et particulièrement à la modification dimensionnelle. En effet, par exemple lorsque le substrat est flexible, la multiplication des modifications dimensionnelles, par exemple des pliures et/ou courbures, affecte la durabilité de tels dispositifs.

Il existe donc un besoin pour un dispositif de mesure et/ou de détection d'un mesurande permettant une mesure robuste et précise d'une variation de ce mesurande et qui est adapté pour une utilisation durable.

EXPOSE DE L'INVENTION

La présente invention concerne un dispositif tel que défini dans la revendication 1.

Par « mesurande » l'on entend une grandeur d'intérêt à mesurer. Un mesurande peut être une concentration de gaz, un taux d'humidité, un taux de vapeur, une concentration en composés organiques volatils, une pression, une température, etc.

Par « motif » l'on entend un schéma de configuration d'un circuit conducteur.

Le dispositif selon la présente invention permet de déterminer un mesurande ou l'évolution d'un mesurande. Par « déterminer un mesurande ou l'évolution d'un mesurande » l'on entend que le dispositif permet de déterminer un mesurande d'une façon qualitative et/ou quantitative. Par « déterminer un mesure de façon qualitative », l'on entend que le dispositif permet de déterminer si un mesurande est présent ou absent. Par métonymie, lorsqu'il est par exemple indiqué que le mesurande est un gaz, l'on entend que le dispositif selon la présente invention permet de déterminer si un gaz est présent ou absent, c'est-à-dire si la concentration de ce gaz est suffisante ou insuffisante pour permettre sa détection par le dispositif. Par « déterminer un mesurande de façon quantitative » l'on entend que le dispositif permet de déterminer un mesurande, par exemple une concentration en gaz.

Un premier motif peut comprendre une bande, un barreau, une hélice, une spirale ou une couche et correspond à une surface ou un volume allongé entre une première extrémité et une seconde extrémité distante de la première extrémité.

Avantageusement, le dispositif selon l'invention comprend un premier motif en une première matière conductrice c'est-à-dire une première matière qui ne s'oppose pas ou très peu à la circulation du courant dans un circuit. Le premier motif a une première impédance, définissant l'opposition que rencontre un courant pour circuler dans le premier motif.

Le second motif peut comprendre une bande, un barreau, une hélice, une spirale ou une couche et correspond à une surface ou un volume allongé entre au moins deux extrémités, le second motif étant au moins disposé entre la première extrémité et la seconde extrémité du premier motif. Selon l'invention revendiquée, le second motif est circonscrit au premier motif. Par circonscrit, il est entendu que le second motif est au moins disposé dans le plan ou le volume délimité par le premier motif. Préférentiellement, le second motif est imbriqué parallèlement au premier motif, c'est-à-dire que le second motif est disposé le long du premier motif au niveau d'au moins un premier contact électrique, au moins dans le plan ou le volume délimité par le premier motif, et s'étendant jusqu'au moins un second contact électrique avec le premier motif.

Par « en contact électrique » l'on entend que le second motif est intimement et électriquement lié au premier motif. L'on entend également par « en contact électrique » que le second motif est adapté de manière à établir une connexion électrique entre au moins deux points du premier motif. Lorsque le premier motif est en contact avec le second motif et que le second motif est conducteur, un courant circulant dans le premier motif peut également circuler dans le second motif en raison du contact électrique du second motif avec le premier motif.

Par exemple, dans le cas particulier d'une spirale formée de plusieurs spires pour le premier motif, le second motif peut être disposé entre les spires de telle manière qu'il forme un contact électrique entre au moins une spire et la spire consécutive, c'est-à-dire que le second motif occupe tout ou partie l'espace inter-spires. De plus, le second motif peut s'étendre au-delà de l'espace inter-spires et recouvrir en tout ou partie les spires du premier motif.

De préférence, la première matière conductrice comprend une matière sélectionnée parmi le cuivre, le platine, le fer, l'acier, l'aluminium, l'argent, l'or, le zinc, le plomb, l'étain, le graphite, le tungstène ou une combinaison de ces matières. Encore plus préférentiellement, la première matière conductrice comprend une matière sélectionnée parmi le cuivre, le platine, l'aluminium, l'argent, l'or et le tungstène ou une combinaison de ces matières.

De préférence, la première matière conductrice est insensible à la variation du mesurande. Par « insensible à la variation du mesurande » l'on entend que la première matière conductrice ne s'oppose pas au courant de manière variable en fonction de l'évolution du mesurande. La variation de l'inductance de l'ensemble formé par le premier motif et le second motif ne dépend ainsi que de la variation de l'inductance du second motif qui évolue en fonction du mesurande. Cela évite notamment des calculs de discrimination entre les variations. Encore plus préférentiellement, la première matière conductrice est insensible à toute variation de grandeur physique. La variation de l'impédance ou de l'inductance de l'ensemble formé par le premier motif et le second motif ne dépend pas de l'influence de l'environnement sur l'impédance du premier motif.

Le choix de la première matière conductrice dépend de l'application visée du dispositif et de son environnement de fonctionnement. Par exemple, dans un environnement lumineux dans lequel le mesurande est un gaz, la première matière conductrice est de préférence au moins peu sensible ou insensible à la variation de la luminosité et du mesurande.

Le choix de la seconde matière dépend de l'application visée du dispositif et de son environnement. Une telle seconde matière est une matière dont la conductivité évolue de façon continue en fonction du mesurande. Par exemple, dans un environnement lumineux dans lequel le mesurande est un gaz, la seconde matière est au moins peu sensible ou insensible à la variation de la luminosité et est sensible à la variation du mesurande. La sensibilité à la variation du mesurande est en relation avec la nature et/ou la concentration du mesurande, dans cet exemple le gaz.

La seconde matière peut comprendre une sélection d'une matière parmi un groupe de matières comprenant le trioxyde de tungstène $WO_3$, l'oxyde de zinc $ZnO$, l'oxyde de cuivre $CuO$, le dioxyde d'étain $SnO_2$, l'oxyde de nickel $NiO$, le dioxyde de titane $TiO_2$, et une combinaison de ces éléments.

Avantageusement, la seconde matière peut être dopée par des particules telles que des particules d'or, d'aluminium, d'argent, de palladium, ou de platine. Le dopage de la seconde matière par des particules permet d'améliorer les performances du capteur. Par exemple, le dopage permet d'améliorer la sensibilité et/ou la sélectivité de la seconde matière au mesurande et donc d'améliorer les performances du capteur comprenant le dispositif de l'invention.

La seconde matière, dopée ou non, permet de détecter en particulier des gaz ou vapeurs et des Composés Organiques Volatils (COV) tels que l'ozone, les oxydes d'azote, l'ammoniac, le monoxyde de carbone, le dioxyde de carbone, le benzène, le toluène, l'éthylbenzène, le xylène, les acétaldéhydes, les formaldéhydes, l'isobutylène, l'éthanol, l'acétone.

De telles secondes matières, dopées ou non, peuvent être utilisées dans le dispositif pour des applications de suivi de la qualité de l'air intérieur et extérieur, par exemple par détection d'un gaz dans l'air. De telles secondes matières, dopées ou non, peuvent également être utilisées pour des applications dans le domaine médical. Par exemple, de telles secondes matières, dopées ou non, peuvent être utilisées dans le dispositif afin de déterminer un mesurande ou l'évolution d'un mesurande tel qu'un gaz d'intérêt, un liquide d'intérêt ou une molécule d'intérêt dans un liquide biologique tel que la sueur, la salive ou le sang, ou dans l'haleine. Un autre exemple d'application dans le domaine médical est la détermination d'un mesurande ou l'évolution d'un mesurande dégagé par perspiration sensible ou insensible. La perspiration insensible correspond aux échanges respiratoires par l'intermédiaire des alvéoles pulmonaires et par évaporation à travers la peau sans sudation. La perspiration sensible correspond à l'évaporation d'eau à la surface de la peau, à partir de la sueur qui s'y est accumulée. Afin de déterminer la perspiration sensible ou insensible, le dispositif peut être compris notamment dans un patch ou un pansement. De telles applications permettent une surveillance ponctuelle ou en continu et en temps réel d'un mesurande.

Alternativement, la seconde matière peut comprendre :

- un matériau souple chargé en carbone ou avec des particules métalliques tel que le caoutchouc, le polybutadiène, le polydiméthylsiloxane,
- un polymère conducteur, par exemple du PEDOT:PSS ou poly(3,4-éthylènedioxythiophène) poly(styrène sulfonate) de sodium,
- un semi-conducteur piézorésistif tel que le silicium ou le germanium,
- une combinaison de ces éléments.

De telles secondes matières peuvent être utilisées dans le dispositif afin de déterminer un mesurande pouvant être une force ou une pression pour des applications industrielles ou dans le domaine médical.

Alternativement, la seconde matière peut comprendre une sélection d'une matière parmi un groupe de matériaux comprenant les matériaux semi-conducteurs homogènes polycristallins ou monocristallins, intrinsèques (purs) ou extrinsèques (dopés), et une combinaison de ces éléments. Des exemples de tels matériaux semi-conducteurs polycristallins peuvent être : CdS, CdSe, CdTe, PbS, PbSe, PbTe. Des exemples de tels matériaux semi-conducteurs monocristallins peuvent être : Sbln, Asln, Pln, CdHgTe et le silicium et le germanium dopés par Au, Cu, Sb, Zn.

De telles secondes matières peuvent être utilisées dans le dispositif afin de déterminer un mesurande, ce mesurande étant la lumière visible ou un rayonnement à des longueurs d'onde dans le domaine de l'infrarouge ou des ultraviolets pour des applications en tant que capteurs optiques. En effet, la seconde matière peut comprendre des cellules photoconductrices qui, grâce au phénomène physique de la photoconduction, ont une conductivité qui varie en fonction de la lumière visible ou d'un rayonnement dans le domaine de l'infrarouge ou des ultraviolets.

Alternativement, la seconde matière peut comprendre une sélection d'une matière parmi un groupe de matières comprenant les métaux tels que le cuivre, le nickel, le platine et le tungstène, et des oxydes métalliques semi-conducteurs polycristallins tels que $MgO$, $MgAl_2O_4$, $Mn_2O_3$, $Fe_3O_4$, $CO_2O_3$, $NiO$, $ZnTiO_4$, et une combinaison de ces éléments.

De telles secondes matières peuvent être utilisées dans le dispositif afin de mesurer la température pour tout type d'applications.

La seconde matière peut comprendre une matière dont la conductivité augmente lorsque la valeur du mesurande augmente.

La seconde matière peut comprendre une matière dont la conductivité diminue lorsque la valeur du mesurande augmente.

Le second motif peut avoir une impédance dont la partie réelle et la partie imaginaire évoluent chacune de manière opposée. Par exemple la partie réelle de l'impédance du second motif peut diminuer alors que la partie imaginaire peut augmenter et inversement.

Selon un mode de réalisation, l'ensemble formé par le premier motif et le second motif du dispositif est essentiellement en deux dimensions. Un tel dispositif présente une disposition générale planaire. Comme présenté plus après, le premier motif et le second motif peuvent notamment former deux spirales s'étendant principalement dans le plan et imbriquée l'une dans l'autre.

Selon un autre mode de réalisation, l'ensemble formé par le premier motif et le second motif du dispositif est essentiellement en trois dimensions. Un tel dispositif présente une disposition générale volumique.

De manière particulière, le second motif est en forme de cylindre creux définissant une surface extérieure et une surface intérieure, le premier motif étant enroulé autour et/ou à l'intérieur du second motif de telle sorte que le premier motif est en contact avec la surface extérieure du second motif et/ou la surface intérieure du second motif et/ou est au moins partiellement dans l'épaisseur du second motif.

Le premier motif peut être configuré de manière à former un cylindre creux d'une première matière conductrice et le second motif peut être configuré d'une manière à former une bande ou un fil, en contact avec le cylindre creux. Le second motif peut par exemple être enroulé de façon hélicoïdale autour et/ou à l'intérieur du premier motif de telle sorte que le premier motif est en contact avec la surface extérieure du premier motif et/ou la surface intérieure du premier motif et/ou est au moins partiellement dans l'épaisseur du premier motif. Le cylindre creux peut alors être adapté pour permettre le passage d'un gaz, liquide ou solide ou un mélange de ces derniers.

De manière similaire, le second motif peut être configuré de manière à former un cylindre creux d'une seconde matière et le premier motif peut être configuré d'une manière à former une bande ou un fil, en contact avec le cylindre creux. Le premier motif peut être enroulé de façon hélicoïdale autour et/ou à l'intérieur du second motif de telle sorte que le premier motif est en contact avec la surface extérieure du second motif et/ou la surface intérieure du second motif et/ou est au moins partiellement dans l'épaisseur du second motif. Le cylindre creux peut alors être adapté pour permettre le passage d'un gaz, liquide ou solide ou un mélange de ces derniers.

Le premier et le second motif peuvent également être disposés sous une forme de deux hélices imbriquées de manière à constituer un cylindre creux.

Par « cylindre » l'on entend toute surface dont les droites génératrices sont parallèles et non seulement les cylindres circulaires droits.

Avantageusement, le premier motif est en forme de spirale à n spires ou présente des méandres.

Avantageusement, le second motif est en forme de spirale à m spires avec $m \leq n,$ ou présente des méandres.

n correspond à un nombre décimal strictement supérieur à 1.

Ces motifs en forme de spirale ou présentant des méandres peuvent être adaptés dans un mode de réalisation essentiellement en deux dimensions et également dans un mode de réalisation essentiellement en trois dimensions.

Le terme « spirale » doit se comprendre dans le sens commun, de sorte qu'un motif en spirale est un motif en enroulement. La forme enroulée peut être circulaire, carrée, rectangulaire, hexagonale. D'autres formes sont possibles pour adapter le dispositif à son utilisation finale.

La spirale peut être constituée de spires coaxiales et/ou coplanaires. De manière particulière et dans un mode de réalisation essentiellement en deux dimensions, les spires du premier motif et/ou du second motif sont préférentiellement disposées de manière planaire. De manière particulière et dans un mode de réalisation essentiellement en trois dimensions, les spires du premier motif et/ou du second motif sont préférentiellement disposées de manière coaxiale.

Par méandres l'on entend une courbe sinueuse constituée d'une pluralité de boucles consécutives dont les courbures sont alternativement dans le sens des aiguilles d'une montre et dans le sens opposé aux aiguilles d'une montre (ou inversement).

Lorsque les motifs sont en forme de spirale, ils peuvent former une self-inductance. Par « self-inductance » l'on entend une bobine d'induction, c'est-à-dire un composant formé de plusieurs spires dans lequel un champ magnétique est induit par le courant circulant dans les spires.

Le second motif est en contact électrique avec le premier motif de telle manière que si le premier motif est disposé en forme de spirale, le second motif est disposé entre les spires consécutives du premier motif de manière à connecter électriquement ces spires consécutives, c'est-à-dire dans tout ou partie de l'espace inter-spires.

Dans un cas particulier, dans le cas d'un premier motif disposé en n spirales, le second motif peut comprendre une première portion entre la spire la plus extérieure et la seconde spire la plus extérieure ainsi qu'une seconde portion entre la spire la plus intérieure et la seconde spire la plus intérieure.

Le traitement du signal mis en oeuvre peut être plus robuste car le dispositif peut être inséré dans un circuit de conditionnement dont la fréquence du signal est l'image du mesurande alors que dans le cas d'un capteur résistif c'est l'amplitude du signal qui contient l'information relative au mesurande. Cela permet que l'immunité au bruit soit alors plus importante et/ou que l'extraction de l'information utile au sein du signal global bruité soit plus aisée qu'en utilisant un capteur résistif.

En outre, le dispositif selon l'invention peut facilement prendre place dans un système de communication sans fil qui pourra transmettre des informations sans contact et être télé-alimenté. En effet, il est possible d'associer au capteur à variation d'inductance un élément inductif. Il y a alors un couplage inductif entre le capteur à variation d'inductance et l'élément inductif s'ils sont placés suffisamment près l'un de l'autre. La mutuelle inductance entre le capteur à variation d'inductance et l'élément inductif suit alors les variations d'inductance du capteur à variation d'inductance. Un transfert de l'information (la variation d'inductance étant l'image du mesurande) est opéré du capteur à variation d'inductance vers l'élément inductif sans que ceux-ci ne soient en contact. Ceci est possible grâce au champ magnétique qui se crée dans une inductance lorsque celle-ci est parcourue par un courant selon la loi de Biot et Savart et le théorème d'Ampère. De même, un transfert d'énergie par couplage magnétique est possible depuis l'élément inductif vers le capteur à variation d'inductance. Si ce transfert d'énergie est suffisant, il est possible d'alimenter sans contact le capteur à variation d'inductance par l'élément inductif, c'est-à-dire par télé-alimentation. Ces principes de transfert d'information ou de télé-alimentation par champ magnétique sont utilisés dans les systèmes de type RFID (Radio Frequency Identification) ou les technologies sans contact de type NFC (Near Field Communication).

De manière avantageuse, le dispositif selon l'invention comprend un substrat formant support du premier motif et du second motif. Par substrat l'on entend un matériau à la surface duquel est disposé un circuit comprenant le premier motif et le second motif. Le substrat peut être un substrat isolant ou passivé. Par isolant l'on entend que le substrat comprend un matériau qui ne permet pas le passage d'un courant électrique.

De manière avantageuse, le premier motif et le second motif sont disposés de manière fixe sur le substrat, c'est-à-dire qu'ils ne sont pas mobiles l'un par rapport à l'autre.

De préférence, le substrat se compose d'un matériau sélectionné parmi un groupe de matériaux comprenant le silicium, l'époxy, les céramiques, le verre, le papier, les plastiques, les élastomères et une combinaison de ces éléments.

De manière avantageuse, le mesurande est un gaz ou une concentration de gaz, une humidité ou un taux d'humidité, une vapeur, un composé organique volatil (COV) ou une concentration d'un COV, une force ou pression, une température, un rayonnement dans le visible, l'infrarouge ou les ultraviolets, une molécule d'intérêt ou une concentration d'une molécule d'intérêt.

Avantageusement, le moyen de détermination de l'inductance comprend un impédancemètre, un inductancemètre ou un analyseur vectoriel de réseau.

De manière encore plus avantageuse, le dispositif comprend au moins un troisième motif en contact électrique au moins avec le premier motif, le troisième motif étant en une troisième matière et ayant une troisième impédance qui évolue de façon continue en fonction d'un second mesurande.

Le dispositif selon l'invention peut avoir un fonctionnement dynamique ou statique. Par fonctionnement dynamique l'on entend que le dispositif selon l'invention nécessite une mesure différentielle entre une première valeur du mesurande et une seconde valeur du mesurande. Par fonctionnement statique l'on entend que le dispositif selon l'invention permet de déterminer un mesurande par une unique mesure. Un étalonnage du dispositif est préférable préalablement avant une utilisation du dispositif fonctionnant de manière statique.

Dans le cas d'un dispositif fonctionnant de manière dynamique, la différence d'inductance mesurée entre un instant $t_0$ où le mesurande, par exemple un gaz, est à une concentration $x_0$ et un instant $t_1$ où le mesurande est à une concentration $x_1$ différente de $x_0$ permet de déterminer une évolution du mesurande.

Dans le cas d'un dispositif fonctionnant de manière statique, une impédance mesurée à un instant $t_0$ permet de déterminer le mesurande, par exemple la présence ou l'absence d'un gaz et/ou sa concentration par l'intermédiaire de l'inductance mesurée.

Avantageusement, le moyen de détermination de l'inductance comprend un inductancemètre.

DESCRIPTION DES FIGURES

[Fig.1] La figure 1 illustre une première variante d'un premier mode de réalisation de l'invention comprenant un premier motif disposé en forme de spirale carrée de 3,5 tours et un second motif en contact électrique avec sensiblement tout le premier motif.

[Fig.2A] La figure 2A illustre la partie conductrice du circuit du dispositif selon la première variante d'un premier mode de réalisation de l'invention lorsque la seconde matière n'est pas électriquement conductrice.

[Fig.2B] La figure 2B illustre la partie conductrice du circuit du dispositif selon la première variante d'un premier mode de réalisation de l'invention lorsque la seconde matière est électriquement conductrice.

[Fig.3] La figure 3 illustre une seconde variante d'un premier mode de réalisation de l'invention comprenant un premier motif disposé sous forme de spirale carrée de 3,5 tours et un second motif en contact électrique avec le premier motif sur seulement une portion du premier motif.

[Fig.4A] La figure 4A illustre la partie conductrice du circuit du dispositif selon la seconde variante d'un premier mode de réalisation de l'invention lorsque la seconde matière n'est pas électriquement conductrice.

[Fig.4B] La figure 4B illustre la partie conductrice du circuit du dispositif selon la seconde variante d'un premier mode de réalisation de l'invention lorsque la seconde matière est électriquement conductrice.

[Fig.5] La figure 5 illustre une troisième variante d'un premier mode de réalisation de l'invention comprenant un premier motif disposé en forme de spirale carrée de 3,5 tours et un second motif en contact électrique avec le premier motif sur une très faible portion du premier motif.

[Fig.6] La figure 6 illustre une quatrième variante d'un premier mode de réalisation de l'invention comprenant un premier motif disposé en forme de spirale carrée de 2,5 tours et un second motif en contact électrique avec tout le premier motif.

[Fig.7] La figure 7 illustre une vue en coupe d'un exemple d'intégration du dispositif de l'invention dans une technologie CMOS.

[Fig.8] La figure 8 illustre une première variante d'un second mode de réalisation de l'invention comprenant un premier motif correspondant à un enroulement autour d'un second motif en forme de cylindre circulaire droit et creux.

[Fig.9] La figure 9 illustre une seconde variante d'un second mode de réalisation de l'invention comprenant un premier motif correspondant à un premier enroulement et un second motif correspondant à un second enroulement, l'ensemble formé par le premier et le second motif étant un cylindre circulaire droit et creux.

EXPOSE DETAILLE DE MODES DE REALISATION PARTICULIERS

De nombreuses variantes des différents modes de réalisation présentés dans cette description sont possibles. La forme du premier motif et celle du second motif est à adapter en fonction de l'environnement dans lequel le dispositif se situe et en fonction du mesurande que le dispositif vise à déterminer. Préférentiellement, le premier motif et le second motif sont organisés de manière à ce que la distance physique à parcourir pour un courant entre un premier point de contact électrique entre le premier motif et le second motif et un second point de contact électrique entre le premier motif et le second motif est plus courte via le second motif uniquement que via le premier motif uniquement.

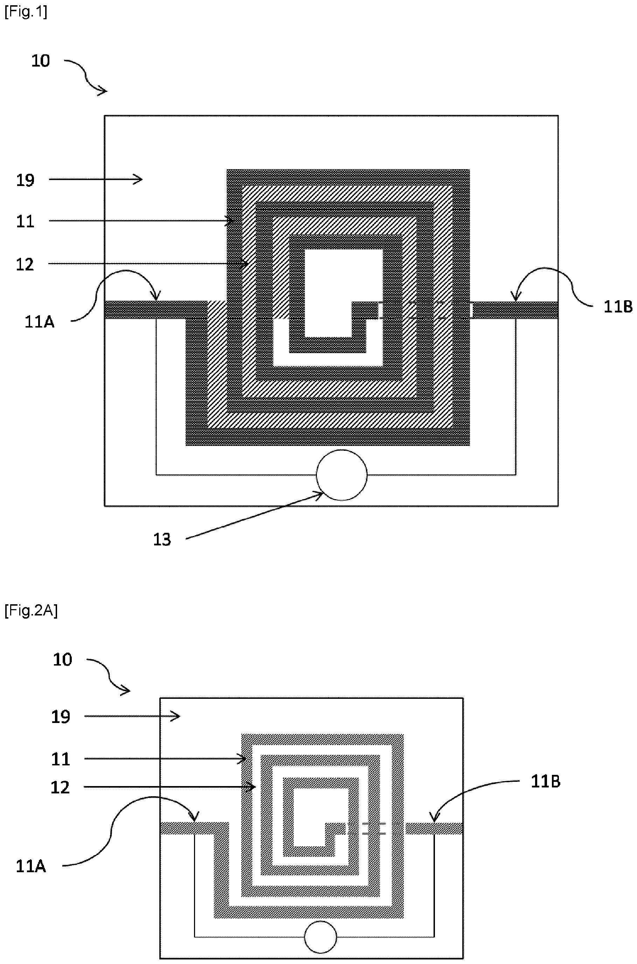

Selon un premier mode de réalisation, l'ensemble formé par le premier motif et le second motif du dispositif est essentiellement en deux dimensions, c'est-à-dire que la hauteur du dispositif est minime par rapport à la longueur ou la largeur du dispositif, la hauteur du dispositif correspondant à l'épaisseur du premier motif. Un tel dispositif peut notamment présenter la disposition générale planaire correspondant aux variantes de réalisations exposées dans les figures 1 à 7. Dans un tel dispositif, le second motif est préférentiellement au moins circonscrit au premier motif, c'est-à-dire au moins disposé dans le plan délimité par le premier motif. Le plan délimité par le premier motif du dispositif essentiellement en deux dimensions correspond à un plan de mêmes longueur et largeur que le premier motif.

Selon un second mode de réalisation, l'ensemble formé par le premier motif et le second motif du dispositif est en trois dimensions. Dans un tel dispositif, le second motif est préférentiellement au moins circonscrit au premier motif, c'est-à-dire au moins disposé dans le volume délimité par le premier motif. Le volume délimité par un premier motif en trois dimensions correspond à un volume de mêmes hauteur, longueur et largeur que le premier motif.

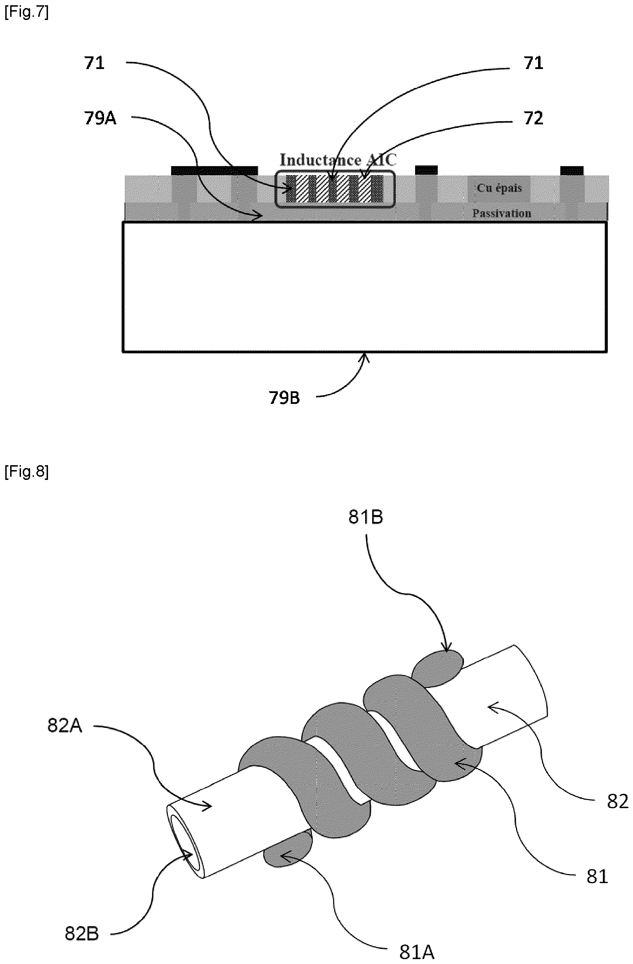

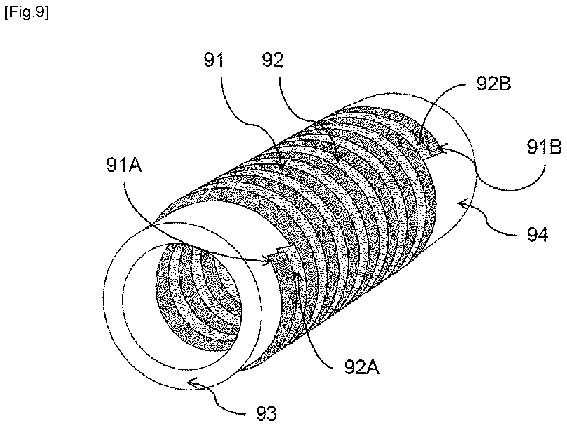

Selon un mode de réalisation particulier au mode en trois dimensions, l'ensemble formé par le premier motif et le second motif du dispositif forme un cylindre. Un tel dispositif est particulièrement représenté dans les figures 8 et 9. Dans un tel dispositif, le second motif est préférentiellement au moins circonscrit au premier motif, c'est-à-dire au moins disposé dans le volume délimité par le premier motif. Par exemple, le volume délimité par le premier motif de la figure 8 ou de la figure 9, le premier motif formant un enroulement, correspond à un volume de même rayon extérieur que l'enroulement et de même longueur que cet enroulement, le second motif étant au moins circonscrit au premier motif, c'est-à-dire au moins disposé dans le volume délimité par le premier motif.

La valeur d'une inductance planaire spirale carrée ou self-inductance telle qu'illustrée peut être estimée analytiquement à partir de la formule suivante sous certaines conditions de validité précisées dans la publication « Simple accurate expressions for planar spirale inductance », S.S. Mohan, M.M. Hershenson, S.P. Boyd, T.H. Lee, IEEE Journal of Solid-State Circuits, Vol. 34, N°10, October 1999, pp. 1419-1424.

$$[\text{Math 1}] \qquad L = 2.34\mu_0 \frac{n^2 d_{avg}}{1+2.75\rho}$$

avec

$$d_{avg} = \frac{d_{out}+d_{in}}{2}$$

et

$$\rho = \frac{d_{out}-d_{in}}{d_{out}+d_{in}}$$

Et où $\mu_0$ est la perméabilité du vide, n le nombre de tours de la spirale, $d_{in}$ le diamètre interne et $d_{out}$ le diamètre externe de l'inductance.

La valeur de l'inductance L est ainsi proportionnelle au carré du nombre de tours de la spirale.

Si l'on considère un premier motif en forme de spirale de dix tours dont la valeur nominale de l'inductance est $L_0$ et que l'on considère un second motif en forme de spirale d'un tour et disposé en contact électrique avec les deux spires consécutives les plus extérieures du premier motif, alors l'ensemble formé par le premier motif et le second motif présente approximativement 9 tours lorsque le mesurande est tel que le second motif est électriquement conducteur. On considère dans ce modèle que le second motif devient électriquement conducteur d'une manière équivalente au premier motif. La valeur de l'inductance est donc réduite d'un facteur 100/81 et l'inductance vaut alors $L_0/(100/81)$.

Si l'on considère un premier motif en forme de spirale de dix tours dont la valeur nominale de l'inductance est $L_0$ et que l'on considère un second motif disposé en forme de spirale de deux tours électriquement en contact avec les spires consécutives les plus extérieures du premier motif, alors l'ensemble formé par le premier motif et le second motif présente approximativement 8 tours lorsque le mesurande est tel que le second motif est électriquement conducteur. On considère dans ce modèle que le second motif devient électriquement conducteur d'une manière équivalente au premier motif. La valeur de l'inductance est donc réduite d'un facteur 100/64 et l'inductance vaut $L_0/(100/64)$.

La figure 1 illustre une première variante de dispositif 10 qui correspond au premier mode de réalisation. Le dispositif comprend un premier motif 11 en une première matière conductrice et un second motif 12 en une seconde matière dont la conductivité est sensible au mesurande. Le premier motif et le second motif sont disposés sur un substrat 19.

Le premier motif 11 comprend une première extrémité 11A et une seconde extrémité 11B. Selon la première variante du premier mode de réalisation, le dispositif 10 comprend également un moyen de détermination 13 configuré pour mesurer l'inductance entre la première extrémité 11A et la seconde extrémité 11B du premier motif 11.

Le premier motif 11 est configuré en une spirale à 3,5 tours et forme une self-inductance. Le second motif 12 est en contact électrique avec le premier motif 11. Le second motif 12 est disposé entre les spires du premier motif 11 de telle manière que les spires formées par le premier motif 11 sont intimement et électriquement liées entre elles par le second motif 12. Par « liées » l'on entend que le second motif 12 forme au moins une connexion entre deux spires consécutives du premier motif 11.

Selon cette première variante, le second motif 12 est en contact électrique avec les spires coplanaires consécutives du premier motif 11, de telle manière que le second motif forme deux spires coplanaires.

La figure 2A illustre en hachuré la partie conductrice du circuit du dispositif 10 selon cette première variante lorsque la seconde matière n'est pas électriquement conductrice. Lorsque le second motif 12 n'est pas électriquement conducteur, la circulation du courant se produit selon la forme géométrique du premier motif 11.

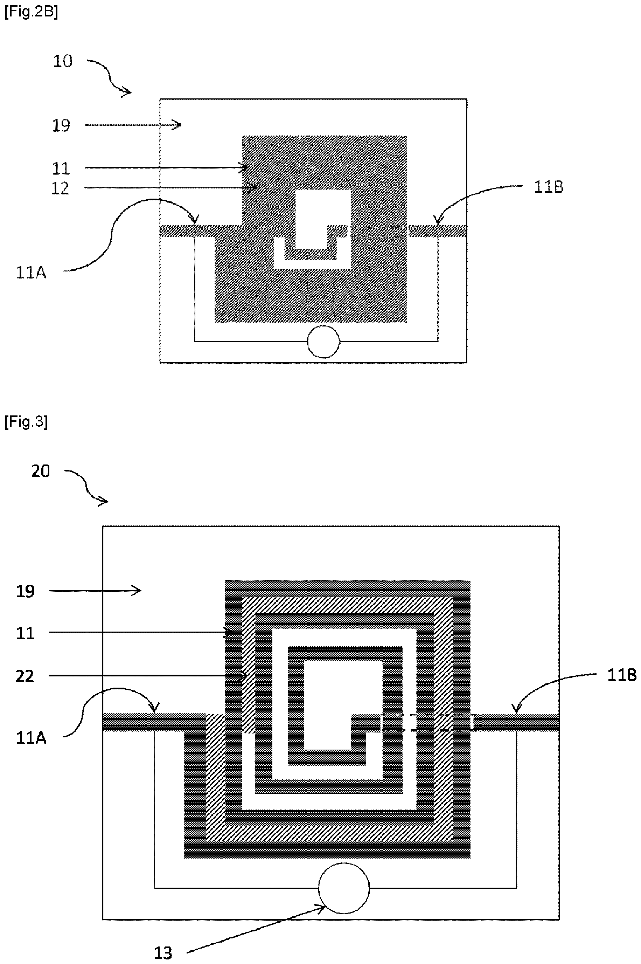

La figure 2B illustre en hachuré la partie conductrice du circuit du dispositif 10 selon cette première variante lorsque la seconde matière est électriquement conductrice. Lorsque le second motif 12 est électriquement conducteur, la circulation du courant se produit selon la forme géométrique du premier motif 11 et du second motif 12.

L'impédance du second motif 12 évolue de façon continue en fonction du mesurande. Ainsi l'impédance de l'ensemble formé par le premier motif et le second motif, mesurée entre la première extrémité 11A et la seconde extrémité 11B, évolue de façon continue en fonction de l'impédance du premier motif 11 et du second motif 12. Lorsque le premier motif 11 est en une matière conductrice qui est substantiellement insensible à la variation du mesurande, c'est-à-dire que son impédance varie substantiellement peu en fonction du mesurande, alors l'impédance mesurée entre la première extrémité 11A et la seconde extrémité 11B varie essentiellement en fonction de l'impédance du second motif 12. Ainsi, l'inductance mesurée entre la première extrémité 11A et la seconde extrémité 11B évolue en fonction de la variation du mesurande.

La figure 3 illustre une seconde variante de dispositif 20 qui correspond au premier mode de réalisation. Le dispositif 20 comprend un premier motif 11 ayant une première impédance et une première extrémité 11A et une seconde extrémité 11B. Le premier motif 11 est disposée sous forme de spirale carrée de 3,5 tours et un second motif 22 est en contact électrique avec le premier motif 11 selon une portion du premier motif 11 qui correspond à la spire la plus extérieure du premier motif et la seconde spire la plus extérieure du premier motif. Le second motif 22 est ainsi disposé en forme de spirale carrée d'un tour, entre les deux spires consécutives les plus extérieures du premier motif 11 et permettant la jonction de ces deux spires consécutives au moyen du second motif.

Selon cette seconde variante, le dispositif 20 comprend un moyen de détermination 13 de l'inductance, disposé entre une première extrémité 11A et une seconde extrémité 11B du premier motif 11. Le moyen de détermination permet de mesurer la valeur de l'impédance présentée par l'ensemble formé par le premier motif 11 et le second motif 22.

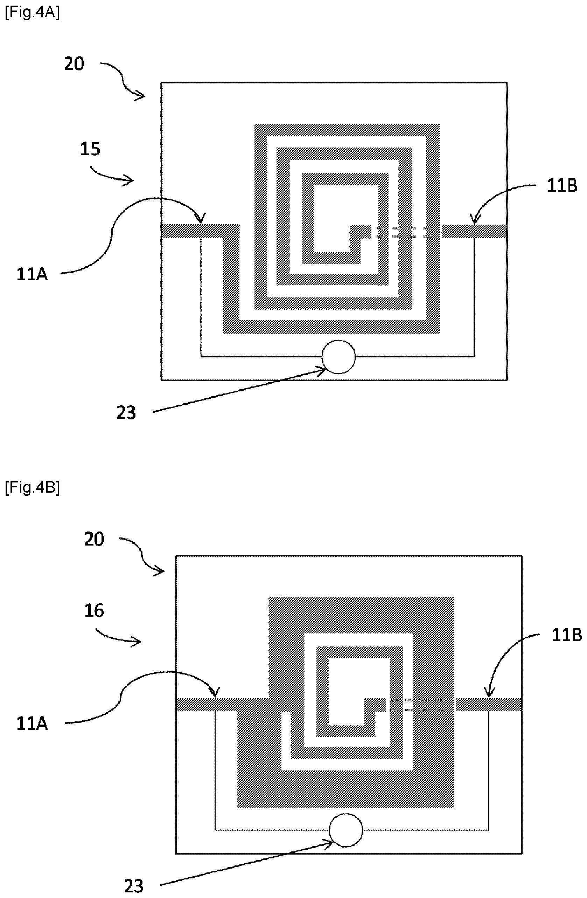

La figure 4A illustre la partie conductrice du circuit du dispositif 20 selon cette seconde variante lorsque la seconde matière n'est pas conductrice. Lorsque le second motif 22 n'est pas électriquement conducteur, la circulation du courant se produit selon la forme géométrique du premier motif 11, c'est-à-dire selon la spirale constituée de 3,5 tours de spires consécutives du premier motif 11. Une impédance ou une inductance générée peut être mesurée entre la première extrémité 11A et la seconde extrémité 11B.

La figure 4B illustre la partie conductrice du circuit du dispositif 20 selon cette seconde variante 20 lorsque la seconde matière est électriquement conductrice. Lorsque le second motif 22 est électriquement conducteur, la circulation du courant se produit selon la forme géométrique du premier motif 11 et du second motif 22.

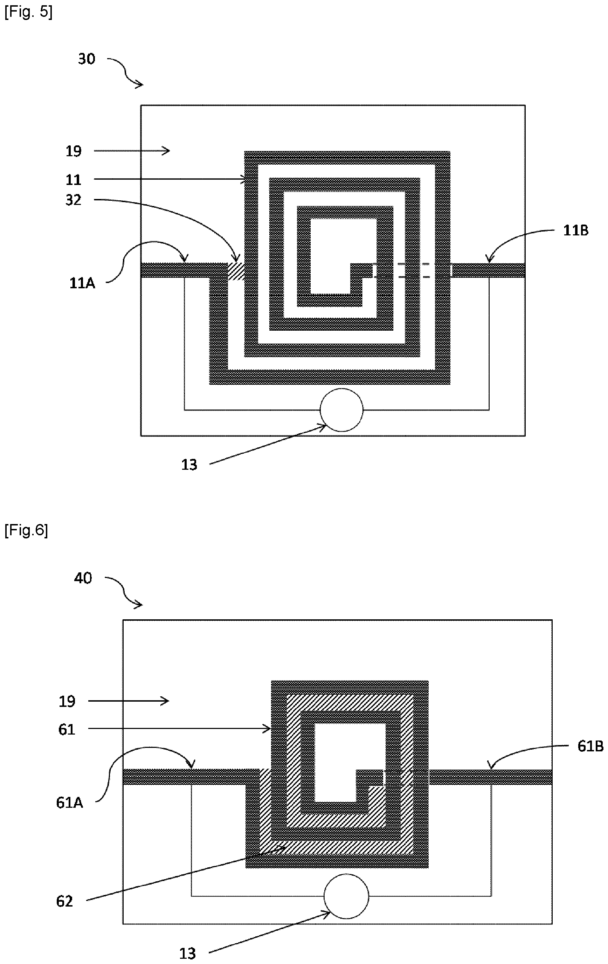

La figure 5 illustre une troisième variante de dispositif 30 correspondant au premier mode de réalisation. Le dispositif 30 comprend un premier motif 11 disposé en forme de spirale carrée de 3,5 tours et un second motif 32 électriquement en contact avec le premier motif 11, le second motif étant disposé entre la spire la plus externe et la seconde spire la plus externe du premier motif 11.

La figure 6 illustre une quatrième variante de dispositif 40 correspondant au premier mode de réalisation de l'invention. Le dispositif 40 comprend un premier motif 61 disposée en forme de spirale carrée de 2,5 tours, le premier motif présentant une première extrémité 61A et une deuxième extrémité 61B distante de la première extrémité, et un second motif 62 électriquement en contact avec le premier motif 61 et disposée en forme de spirale carrée de 1,5 tours.

La figure 7 illustre une vue en coupe d'un exemple d'intégration du dispositif dans une technologie du type « Complementary Métal Oxide Semiconductor » (CMOS). Le dispositif selon l'invention est intégré en Above IC (Integrated Circuit), c'est-à-dire au-dessus d'une couche de passivation 79A et d'un substrat en silicium 79B. Dans le cas d'une application à un capteur capable de déterminer un mesurande dans l'air, par exemple déterminer la présence ou l'absence d'un gaz ou d'un composé organique volatil présent dans l'air ou déterminer la concentration d'un gaz ou d'un composé organique volatil présent dans l'air, le dispositif selon l'invention peut être intégré au-dessus de la couche de passivation 79A afin que le dispositif puisse être au contact de l'air, donc par exemple au contact d'un gaz ou d'un composé organique volatil présent dans l'air.

Dans cet exemple d'intégration du dispositif illustré par la figure 7, le premier motif 71 est une inductance spirale réalisée au-dessus d'une couche de passivation 79A. Le second motif 72 est disposé entre les spires de l'inductance spirale du premier motif 71 et est en contact électrique avec celles-ci. L'inductance spirale du premier motif 71 peut être de forme carrée, hexagonale, octogonale ou circulaire. De manière similaire, le second motif 72 peut être de forme analogue à celle du premier motif.

Une autre variante de dispositif selon l'invention (non illustrée) peut être réalisée avec un premier et un second motif en forme de spirales circulaires. Ces motifs peuvent être réalisés grâce à des technologies d'impression sur supports souples voire étirables, typiquement par sérigraphie ou par jet d'encre, par exemple avec une encre d'argent. Selon cette variante, le dispositif comprend un substrat isolant, sur lequel les motifs s'appuient, présentant des permittivités relatives $\varepsilon_r$ faibles, notamment inférieures à 5 et des épaisseurs allant de quelques micromètres à plusieurs centaines de micromètres. Le substrat isolant est par exemple de type papier, plastique ou élastomère. Le second motif comprend une seconde matière sensible à une pression ou à une contrainte mécanique et dont la résistivité change en fonction de la force (pression ou contrainte) appliquée. Par exemple, les matériaux piézorésistifs et notamment les semi-conducteurs peuvent être utilisés. Un tel dispositif pourrait être utilisé tel un capteur de force ou de pression.

Un tel dispositif peut être avantageusement utilisé pour réaliser un capteur de gaz, vapeurs ou COV, pour lesquels les réactions se font en surface plutôt qu'en volume, et pour lesquels de grandes surfaces en silicium ne sont pas adaptées car celles-ci sont coûteuses, rigides et lourdes. Un tel dispositif comprenant des motifs sur support souple est flexible, conformable et léger en plus d'être peu coûteux.

La figure 8 illustre une vue en trois dimensions d'une première variante d'un second mode de réalisation comprenant un premier motif 81 présentant une première extrémité 81A et une seconde extrémité 81B et correspondant à un enroulement ou bobine autour d'un second motif 82 en forme de cylindre circulaire droit et creux, le second motif définissant une surface extérieure 82A et une surface intérieure 82B. Le second motif définit un espace intérieur qui permet le passage d'un liquide, gaz ou solide ou un mélange de ces derniers d'une extrémité du second motif à une extrémité opposée du second motif. Cette première variante d'un second mode de réalisation comprend également un moyen de détermination (non représenté) de l'inductance de l'ensemble formé par le premier motif et le second motif.

Par exemple, un liquide peut passer dans l'espace intérieur du second motif, d'une première extrémité à une extrémité opposée. Dans le cas d'un mesurande étant la concentration d'un gaz spécifique dans le liquide, l'impédance du second motif évoluera de façon continue en fonction de la concentration de ce gaz spécifique lorsqu'il entre en contact avec le second motif. L'inductance de l'ensemble formé par le premier motif et le second motif évolue donc de façon continue en fonction du mesurande. Le dispositif permet par exemple de surveiller une pollution d'un liquide par un gaz à l'intérieur du cylindre creux.

Selon cette première variante d'un second mode de réalisation, le premier motif est disposé d'une telle manière qu'un liquide, solide ou gaz passant d'une première extrémité du second motif à une extrémité opposée du second motif entre en contact avec le second motif mais n'entre pas en contact avec le premier motif.

De nombreuses variantes du second mode de réalisation sont possibles et il peut être adapté en fonction de l'environnement et du mesurande. Le dispositif peut être adapté de telle sorte que le premier motif puisse être en contact avec le solide, liquide ou gaz passant d'une extrémité du second motif à une extrémité opposée du second motif.

La figure 9 illustre une vue en trois dimensions d'une seconde variante du second mode de réalisation comprenant un premier motif 91 présentant une première extrémité 91A et une seconde extrémité 91B et un second motif 92 présentant une première extrémité 92A et une seconde extrémité 92B. L'ensemble formé par le premier motif et le second motif correspond à un cylindre permettant de relier un premier cylindre 93 à un second cylindre 94. Cette seconde variante d'un second mode de réalisation comprend également un moyen de détermination (non représenté) de l'inductance de l'ensemble formé par le premier motif et le second motif.

Selon cette seconde variante d'un second mode de réalisation, le premier motif et le second motif sont disposés de telle manière qu'un liquide, solide ou gaz passant d'une première extrémité du premier motif à une extrémité opposée du premier motif entre en contact avec le premier motif et le second motif.

De nombreuses autres variantes du second mode de réalisation sont possibles et l'homme du métier saura adapter la forme de l'ensemble formé par le premier motif et le second motif ainsi que la disposition du premier motif et du second motif en fonction du mesurande et/ou de l'environnement dans lequel le dispositif est utilisé.

**Revendications**

1. Dispositif pour déterminer un mesurande comprenant :

   - un premier motif (11, 61, 71, 81, 91) en une première matière conductrice, le premier motif ayant une première impédance et présentant une première extrémité (11A, 61A, 81A, 91A) et une seconde extrémité (11B, 61B, 81B, 91B) distante de la première extrémité,
   - un second motif (12, 62, 72, 82, 92) au moins disposé entre la première extrémité et la seconde extrémité et circonscrit au premier motif, le second motif étant en contact électrique avec le premier motif de manière à établir une connexion électrique entre au moins deux points du premier motif, le second motif étant en une seconde matière et ayant une seconde impédance qui évolue de façon continue en fonction du mesurande, de sorte que l'inductance de l'ensemble formé par le premier motif et le second motif évolue de façon continue en fonction du mesurande,
   - un moyen de détermination (13) de l'inductance de l'ensemble formé par le premier motif et le second motif.

2. Dispositif selon la revendication précédente, la première matière conductrice étant insensible ou peu sensible à la variation du mesurande.

3. Dispositif selon l'une des revendications précédentes, la seconde matière étant une matière ayant une conductivité qui évolue de façon continue en fonction du mesurande.

4. Dispositif selon la revendication 3, la seconde matière étant une matière dont la conductivité augmente lorsque la valeur du mesurande augmente.

5. Dispositif selon la revendication 3, la seconde matière étant une matière dont la conductivité diminue lorsque la valeur du mesurande augmente.

6. Dispositif selon l'une des revendications précédentes, l'ensemble formé par le premier motif et le second motif étant essentiellement en deux dimensions.

7. Dispositif selon l'une des revendications 1 à 5, l'ensemble formé par le premier motif et le second motif étant essentiellement en trois dimensions.

8. Dispositif selon la revendication 7, le second motif étant en forme de cylindre creux définissant une surface extérieure (82A) et une surface intérieure (82B), le premier motif étant enroulé autour ou en plus à l'intérieur du second motif de telle sorte que le premier motif est en contact avec la surface extérieure du second motif ou en plus avec la surface intérieure du second motif et/ou est dans l'épaisseur du second motif.

9. Dispositif selon l'une des revendications précédentes, le premier motif étant en forme de spirale à n spires ou présentant des méandres.

10. Dispositif selon la revendication 9, le second motif étant en forme de spirale à m spires avec $m \leq n$, ou présentant des méandres.

11. Dispositif selon l'une des revendications précédentes, comprenant un substrat (19, 79) formant support du premier motif et du second motif.

12. Dispositif selon l'une des revendications précédentes, le mesurande étant choisi parmi une liste comprenant : un gaz ou une concentration de gaz, une humidité ou un taux d'humidité, une vapeur, un composé organique volatil, COV, ou une concentration d'un COV, une force ou pression, une température, un rayonnement dans le visible, l'infrarouge ou les ultraviolets, une molécule d'intérêt ou une concentration d'une molécule d'intérêt.

13. Dispositif selon l'une des revendications précédentes, le moyen de détermination de l'inductance pouvant comprendre un inductancemètre ou un analyseur vectoriel de réseau.

14. Dispositif selon la revendication 13, le moyen de détermination (13) de l'inductance comprenant un inductancemètre.

**Patentansprüche**

1. Vorrichtung zum Bestimmen einer Messgröße, Folgendes umfassend:

   - ein erstes Muster (11, 61, 71, 81, 91), das aus einem ersten leitfähigen Material besteht, wobei das erste Muster eine erste Impedanz aufweist und ein erstes Ende (11A, 61A, 81A, 91A) und ein zweites Ende (11B, 61B, 81B, 91B), das von dem ersten Ende entfernt ist, aufweist,
- ein zweites Muster (12, 62, 72, 82, 92), das mindestens zwischen dem ersten Ende und dem zweiten Ende angeordnet ist und das erste Muster umschreibt, wobei das zweite Muster derart in elektrischem Kontakt mit dem ersten Muster steht, dass eine elektrische Verbindung zwischen mindestens zwei Punkten des ersten Musters hergestellt wird, wobei das zweite Muster aus einem zweiten Material besteht und eine zweite Impedanz aufweist, die sich kontinuierlich in Abhängigkeit von der Messgröße ändert, sodass sich die Induktivität der von der ersten Muster und dem zweiten Muster gebildeten Anordnung kontinuierlich in Abhängigkeit von der Messgröße ändert,
- ein Mittel zum Bestimmen (13) der Induktivität der von dem ersten Muster und dem zweiten Muster gebildeten Anordnung.

2. Vorrichtung nach dem vorhergehenden Anspruch, wobei das erste leitfähige Material gegenüber der Änderung der Messgröße nicht empfindlich oder wenig empfindlich ist.

3. Vorrichtung nach einem der vorhergehenden Ansprüche, wobei das zweite Material ein Material ist, das eine Leitfähigkeit aufweist, die sich kontinuierlich in Abhängigkeit von der Messgröße ändert.

4. Vorrichtung nach Anspruch 3, wobei das zweite Material ein Material ist, dessen Leitfähigkeit zunimmt, wenn der Wert der Messgröße zunimmt.

5. Vorrichtung nach Anspruch 3, wobei das zweite Material ein Material ist, dessen Leitfähigkeit abnimmt, wenn der Wert der Messgröße zunimmt.

6. Vorrichtung nach einem der vorhergehenden Ansprüche, wobei die von dem ersten Muster und dem zweiten Muster gebildete Anordnung im Wesentlichen zweidimensional ist.

7. Vorrichtung nach einem der Ansprüche 1 bis 5, wobei die von dem ersten Muster und dem zweiten Muster gebildete Anordnung im Wesentlichen dreidimensional ist.

8. Vorrichtung nach Anspruch 7, wobei das zweite Muster die Form eines Hohlzylinders aufweist, der eine Außenfläche (82A) und eine Innenfläche (82B) definiert,
wobei das erste Muster um das zweite Muster oder zusätzlich innerhalb des zweiten Musters derart gewickelt ist, dass das erste Muster in Kontakt mit der Außenfläche des zweiten Musters oder zusätzlich mit der Innenfläche des zweiten Musters steht und/oder in der Dicke des zweiten Musters liegt.

9. Vorrichtung nach einem der vorhergehenden Ansprüche, wobei das erste Muster die Form einer Spirale mit n Windungen hat oder Mäander aufweist.

10. Vorrichtung nach Anspruch 9, wobei das zweite Muster die Form einer Spirale mit $m$ Windungen, wobei $m \leq n,$ hat oder Mäander aufweist.

11. Vorrichtung nach einem der vorhergehenden Ansprüche, umfassend ein Substrat (19, 79), das einen Träger des ersten Musters und des zweiten Musters bildet.

12. Vorrichtung nach einem der vorhergehenden Ansprüche, wobei die Messgröße aus einer Liste ausgewählt ist, die Folgendes umfasst: ein Gas oder eine Gaskonzentration, eine Feuchtigkeit oder einen Feuchtigkeitsgehalt, einen Dampf, eine flüchtige organische Verbindung, VOC, oder eine Konzentration einer VOC, eine Kraft oder einen Druck, eine Temperatur, eine sichtbare, Infrarot- oder Ultraviolett-Strahlung, ein Molekül von Interesse oder eine Konzentration eines Moleküls von Interesse.

13. Vorrichtung nach einem der vorhergehenden Ansprüche, wobei das Mittel zum Bestimmen der Induktivität ein Induktivitätsmessgerät oder einen Vektor-Netzwerkanalysator umfassen kann.

14. Vorrichtung nach Anspruch 13, wobei das Mittel zum Bestimmen (13) der Induktivität ein Induktivitätsmessgerät umfasst.

**Claims**

1. A device for determining a measurand, comprising:

- a first pattern (11, 61, 71, 81, 91) made of a first conductive material, the first pattern having a first impedance and having a first end (11A, 61A, 81A, 91A) and a second end (11B, 61B, 81B, 91B) at a distance from the first end,
- a second pattern (12, 62, 72, 82, 92) at least arranged between the first end and the second end and circumscribing the first pattern, the second pattern being in electrical contact with the first pattern so as to establish an electrical connection between at least two points of the first pattern, the second pattern being made of a second material and having a second impedance that changes continuously as a function of the measurand, such that the inductance of the assembly formed by the first pattern and the second pattern changes continuously as a function of the measurand,
- a means (13) for determining the inductance of the assembly formed by the first pattern and the second pattern.

2. The device as claimed in the preceding claim, the first conductive material being insensitive or barely sensitive to the variation of the measurand.

3. The device as claimed in one of the preceding claims, the second material being a material having a conductivity that changes continuously as a function of the measurand.

4. The device as claimed in claim 3, the second material being a material whose conductivity increases when the value of the measurand increases.

5. The device as claimed in claim 3, the second material being a material whose conductivity decreases when the value of the measurand increases.

6. The device as claimed in one of the preceding claims, the assembly formed by the first pattern and the second pattern being essentially two-dimensional.

7. The device as claimed in one of claims 1 to 5, the assembly formed by the first pattern and the second pattern being essentially three-dimensional.

8. The device as claimed in claim 7, the second pattern taking the form of a hollow cylinder defining an outer surface (82A) and an inner surface (82B), the first pattern being wrapped around or additionally inside the second pattern such that the first pattern is in contact with the outer surface of the second pattern or additionally with the inner surface of the second pattern and/or is in the thickness of the second pattern.

9. The device as claimed in one of the preceding claims, the first pattern taking the form of a spiral with n turns or exhibiting meanders.

10. The device as claimed in claim 9, the second pattern taking the form of a spiral with $m$ turns with $m \leq n,$ or exhibiting meanders.

11. The device as claimed in one of the preceding claims, comprising a substrate (19, 79) forming a support for the first pattern and the second pattern.

12. The device as claimed in one of the preceding claims, the measurand being chosen from a list comprising: a gas or a gas concentration, a humidity or a moisture content, a vapor, a volatile organic compound, VOC, or a concentration of a VOC, a force or pressure, a temperature, visible, infrared or ultraviolet radiation, a molecule of interest or a concentration of a molecule of interest.

13. The device as claimed in one of the preceding claims, the means for determining the inductance possibly comprising an inductance meter or a vector network analyser.

14. The device as claimed in claim 13, the means (13) for determining the inductance comprising an inductance meter.

[Fig.1]

[Fig.2A]

[Fig.2B]

[Fig.3]

[Fig.4A]

[Fig.4B]

[Fig. 5]

[Fig.6]

[Fig.7]

[Fig.8]

[Fig.9]

## RÉFÉRENCES CITÉES DANS LA DESCRIPTION

**Documents brevets cités dans la description**

- US 20080007384 A
- WO 2008011260 A
- WO 200811260 A
- US 2005284231 A1

**Littérature non-brevet citée dans la description**

- **S.S. MOHAN ; M.M. HERSHENSON ; S.P. BOYD ; T.H. LEE.** Simple accurate expressions for planar spirale inductance. *IEEE Journal of Solid-State Circuits,* Octobre 1999, vol. 34 (10), 1419-1424